Europäisches Patentamt

European Patent Office

Office européen des brevets

(11) Veröffentlichungsnummer: **0 584 874 A2**

# EUROPÄISCHE PATENTANMELDUNG

(21) Anmeldenummer: 93202438.3

(51) Int. Cl.5: **G01R 33/035**

(22) Anmeldetag: **18.08.93**

(30) Priorität: **22.08.92 DE 4227877**

(43) Veröffentlichungstag der Anmeldung:
**02.03.94 Patentblatt 94/09**

(84) Benannte Vertragsstaaten:
**DE FR GB**

(71) Anmelder: **Philips Patentverwaltung GmbH**
**Wendenstrasse 35c**
**D-20097 Hamburg(DE)**
(84) **DE**

(71) Anmelder: **PHILIPS ELECTRONICS N.V.**
**Groenewoudseweg 1**
**NL-5621 BA Eindhoven(NL)**
(84) **FR GB**

(72) Erfinder: **David, Bernd Rudi, c/o PHILIPS**
**PATENTVERWALTUNG**
**GMBH,**
**Wendenstrasse 35c**
**D-20097 Hamburg(DE)**
Erfinder: **Dössel, Helmut O., Dr., c/o PHILIPS**
**PATENTVERWALT.**
**GMBH,**
**Wendenstrasse 35c**
**D-20097 Hamburg(DE)**
Erfinder: **Edeler, Wilfried, c/o PHILIPS**
**PATENTVERWALT.**
**GMBH,**
**Wendenstrasse 35c**
**D-20097 Hamburg(DE)**
Erfinder: **Hoppe, Wolfgang, c/o PHILIPS**
**PATENTVERWALT.**
**GMBH,**
**Wendenstrasse 35c**
**D-20097 Hamburg(DE)**
Erfinder: **Kobs, Rolf Udo Dieter, c/o PHILIPS**
**PATENTVERWALT.**
**GMBH,**
**Wendenstrasse 35c**
**D-20097 Hamburg(DE)**
Erfinder: **Lüdecke, Kai-Michael c/o PHILIPS**
**PATENTVERW.GMBH**
**Wendenstrasse 35c**
**D-20097 Hamburg(DE)**
Erfinder: **Krüger, Joh.E.W. c/o PHILIPS**
**PATENTVERW.GMBH**
**Wendenstrasse 35c**
**D-20097 Hamburg(DE)**
Erfinder: **Rabe, Gert c/o PHILIPS**
**PATENTVERWALTUNG GMBH**
**Wendenstrasse 35c**
**D-20097 Hamburg(DE)**

(74) Vertreter: **Kupfermann, Fritz-Joachim,**
**Dipl.-Ing.**
**Philips Patentverwaltung GmbH,**
**Wendenstrasse 35c**
**D-20097 Hamburg (DE)**

(54) **Miniaturisiertes SQUID-Modul insbesondere für Vielkanal-Magnetometer.**

(57) Miniaturisiertes SQUID-Modul (10) insbesondere für Vielkanal-Magnetometer zur Messung sich ändernder Magnetfelder in einem Feldstärkebereich unter $10^{-10}$ T, insbesondere unter $10^{-12}$ T, mit supraleitenden und geschirmten Verbindungen zwischen einem SQUID-Chip (19) und einem Gradiometer (12), das im unteren Bereich eines Kryostaten montierbar ist und eine große Anzahl von Meßpunkten je Flächeneinheit ermöglicht, wobei der SQUID-Chip (19) auf einer nur einige Millimeter breiten vollständig geschirmten Trägerplatte (18) mit elektronischer Beschaltung (23) angeordnet ist und daß der SQUID-Chip (19) über einen supraleitenden, lötfähigen und bondfähigen Zwischenträger (27) mindestens durch Löten mit den Drähten (11) des Gradiometers (12) supraleitend verbunden ist.

EP 0 584 874 A2

Fig.2

2

Die vorliegende Erfindung betrifft ein miniaturisiertes SQUID-Modul insbesondere für Vielkanal-Magnetometer zur Messung sich ändernder Magnetfelder in einem Feldstärkebereich unter $10^{-10}$ T, insbesondere unter $10^{-12}$ T, mit supraleitenden und geschirmten Verbindungen zwischen einem SQUID-Chip und einem Gradiometer.

Vielkanal-Magnetometer werden z.B. in der Funktionsdiagnostik des menschlichen Herzens und Hirns eingesetzt, um die elektrischen Ströme auf den Nervenbahnen abzubilden. Hierzu werden die durch die Ströme erzeugten kleinen Magnetfelder außerhalb des Köpers gemessen. Diese Magnetfelder reichen bis in den Bereich von 100 fT ($100 \cdot 10^{-15}$ T) herab und können nur mit supraleitenden Bauelementen, den SQUID's (Superconducting Quantum Interference Devices) gemessen werden. Üblicherweise werden die zu messenden Felder mit sogenannten Gradiometern erfaßt, die nur für Feldgradienten, nicht aber für homogene Felder empfindlich sind. So können Störsignale von weit entfernten Quellen unterdrückt werden. Der Abgleich solcher Gradiometer, d.h. der Unterdrückungsfaktor für störende homogene Felder, sollte kleiner als $10^{-4}$ sein. Von den Gradiometern wird das zu messende Signal über verdrillte supraleitende Drähte zum SQUID gebracht und mit einer Spule induktiv eingekoppelt. Da das SQUID nicht direkt auf äußere Magnetfelder ansprechen soll, sondern die vom Gradiometer kommenden Signale messen soll, wird das SQUID üblicherweise in einer supraleitenden Magnetfeldabschirmung betrieben.

Derartige Magnetometer-Anordnungen sind beispielsweise aus der weiter unten genannten Literatur und aus der EP-A1-0 200 956 bekannt. Letztere betrifft eine konstruktiv verhältnismäßig aufwendige Vorrichtung zu Messung schwacher Magnetfelder mit einer Vielzahl von supraleitenden Verbindungen zwischen einem SQUID-Array, das auf einem mit Kontaktpads versehenen Substrat angeordnet ist, und einem Gradiometer-Array, das für die supraleitenden Verbindungen u.a. einen mechanisch recht aufwendigen Kontaktkamm aufweist.

Eine genaue Analyse hat nun gezeigt, daß die im Stand der Technik bekannte supraleitende Magnetfeldabschirmung selbst durch ihre Feldverdrängung homogene Magnetfelder verzerrt, und somit zu einem scheinbaren Feldabgleich des Gradiometers führt, auch wenn das Gradiometer selbst durch eine präzise Herstellung optimal abgeglichen ist.

Um die Größenordnung der durch supraleitende SQUID-Abschirmungen verursachten Feldverzerrung abzuschätzen, kann der Feldabgleich E berechnet werden für ein Gradiometer erster Ordnung mit einem Radius r, verursacht durch eine supraleitende Scheibe mit einem Radius a, die sich zu oberen bzw. unteren Windung des Gradiometers in einer Entfernung $z_1$ bzw. $z_2$ befindet. Nach einem Aufsatz von "J.A. Overweg, M.J. Walter-Peters", Cryogenics, 529 (1978), ergibt sich:

$$E = \frac{2}{\pi} \left\{ \frac{v(z_2, a)}{v^2(z_2, a) + 1} + atan(v(z_2, a)) - \frac{v(z_1, a)}{v^2(z_1, a) + 1} - atan(v(z_1, a)) \right\}$$

mit

$$v(z, a) = \frac{\sqrt{z^2 + r^2 - a^2 + \sqrt{(z^2 + r^2 - a^2)^2 + 4 \cdot a^2 \cdot z^2}}}{a \cdot \sqrt{2}}$$

Als Beispiel kann der Feldabgleich einer supraleitenden Scheibe von 5 mm bzw. 10 mm Durchmesser für verschiedene Abstände zu einem Gradiometer erster Ordnung mit 20 mm Durchmesser und 50 mm Basislänge berechnet werden. Als Ergebnis ist festzustellen, daß ein SQUID-Gehäuse von 10 mm Durchmesser mindestens 75 mm vom Gradiometer entfernt sein muß, damit der scheinbare Fehlabgleich kleiner als $10^{-4}$ bleibt. Diese Größenverhältnisse haben jedoch erhebliche Nachteile hinsichtlich der erforderlichen Kühlung in einem Kryostaten und der Anordnung einer Vielzahl von SQUID-Modulen in einem Vielkanal-Magnetometer.

Mit Hilfe einer Formel aus dem Aufsatz von "H.J.M. ter Brake et. al.", IC SQUID 91, pp. 521 - 524, (1991), lassen sich auch noch seitlich versetzte SQUID-Abschirmungen in einem Vielkanal-System berücksichtigen. So ergibt sich beispielsweise für ein 19-Kanal-System mit 25 mm Kanalabstand, daß die SQUID-Module bei 10 mm Durchmesser mindestens 150 mm von den Gradiometern entfernt sein müssen. Diese Größenverhältnisse bei Vielkanal-Magnetometern sind also noch schlechter, was sich letztlich auch auf die mögliche Anzahl der Meßpunkte je Flächeneinheit nachteilig auswirkt.

Die weiter aus Aufsätzen von "H.E. Hoening et. al.", IEEE Trans. Magn., MAG27, 2777 (1991), "J. Knuutila et. al.", Rev. Sci. Instrum. 58, 2145 (1987), "M.B. Ketchen.", IEEE Trans. Magn., MAG23, 1650 (1987) und "D.L. Fleming", IEEE Trans. Magn., MAG21, 658 (1985), bekannten SQUID-Module bewegen sich in dieser Größenordnung bzw. sind teilweise noch ungünstiger, da sie zum Teil eine aufwendige SQUID-Chip-Montage, einen komplizierten Anschluß der supraleitenden Drähte, einen großen Behälter zur supraleitenden Abschirmung, eine unvorteilhafte Anordnung zum Anschluß der Kabel zur SQUID-Elektronik oder einen großen Transformator zur Impedanzanpassung enthalten.

Aufgabe der vorliegenden Erfindung ist es, ein miniaturisiertes SQUID-Modul insbesondere für Vielkanal-Magnetometer zu schaffen, das möglichst vollständig im unteren Bereich eines Kryostaten montiert werden kann und eine große Anzahl von Meßpunkten je Flächeneinheit ermöglicht.

Erfindungsgemäß wird diese Aufgabe dadurch gelöst, daß der SQUID-Chip auf einer nur einige Millimeter breiten vollständig geschirmten Trägerplatte mit elektronischer Beschaltung angeordnet ist und daß der SQUID-Chip über einen supraleitenden, lötfähigen und bondfähigen Zwischenträger mindestens durch Löten mit den Drähten des Gradiometers supraleitend verbunden ist.

Weitere bevorzugte Ausgestaltungen der Erfindung ergeben sich aus den Unteransprüchen.

Aus der o.g. Formel für ein einzelnes SQUID-Modul kann also bei vorgegebenem Abstand zwischen SQUID-Modul und Gradiometer eine Abschätzung der Größenverhältnisse des SQUID-Moduls erfolgen. Danach kann das SQUID-Modul bis auf 40 mm an das Gradiometer herangeführt werden, wenn es gelingen sollte, das SQUID bzw. den SQUID-Chip in einem Gehäuse von nur 5 mm Durchmesser unterzubringen.

Für ein Vielkanalsystem würde dann, nach obiger Berechnung, bei 5 mm Gehäusedurchmesser schon ein Abstand von 85 mm zwischen SQUID-Modul und Gradiometer ausreichen. Dieser Abstand ist wesentlich kleiner als der bei Anordnungen im Stand der Technik mögliche. Ein möglichst kleiner Abstand ist besonders vorteilhaft, weil dann das supraleitende Meßsystem vollständig im Bodenbereich beispielsweise eines Helium-Kryostaten untergebracht werden kann, und damit auch der zeitliche Abstand zwischen dem Helium-Nachfüllen verlängert werden kann. Da ein solches erfindungsgemäßes SQUID-Modul auch einen wesentlich geringeren Durchmesser aufweist als die im Stand der Technik bekannten SQUID-Module, ist auch ein Vielkanal-Magnetometer mit einer erheblich höheren Anzahl von Meßpunkten pro Flächeneinheit möglich.

Um entsprechende Abmessungen zu realisieren, wird erfindungsgemäß der SQUID-Chip auf eine Trägerplatte z.B. aus Keramik, die schmaler als ca. 4 mm ist, aufgeklebt und angebondet. Die zur elektrischen Beschaltung des SQUID's nötigen Leiterbahnen, Widerstände bzw. elektronischen Bauelemente werden z.B. vorteilhaft in Dickschichttechnik direkt auf den keramischen Träger aufgedruckt. Bei einer ersten Ausgestaltung der Erfindung werden die zur Einkopplung der Signale vom Gradiometer benötigten supraleitenden Verbindungen durch Löten hergestellt. Hierzu werden schmale Bändchen beispielsweise aus einer PbInAu-Legierung, die sich als besonders stabil in ihren supraleitenden Eigenschaften erwiesen hat, auf den SQUID-Chip einerseits und andererseits auf einen Lötstützpunkt auf dem keramischen Träger gelötet. Die supraleitenden Drähte vom Gradiometer werden dann an den entsprechenden Lötstützpunkten auf den keramischen Träger gelötet.

Gemäß einer weiteren vorteilhaften Ausgestaltung der supraleitenden Verbindung zum Gradiometer können die schmalen Bändchen z.B. aus der PbInAu-Legierung auf den keramischen Träger aufgeklebt sein. Die Verbindung mit dem SQUID-Chip erfolgt dann durch Bonden von duktilem Niob-Draht direkt auf dem PbInAu-Bändchen und die Verbindung mit dem Gradiometer durch Löten der supraleitenden Drähte auf der anderen Seite des PbInAu-Bändchens. Durch diese Art der supraleitenden Ankopplung wird vorteilhaft eine mikroskopische Verbindungstechnologie (Bonden) auf der Seite des SQUID-Chips mit einer makroskopischen Verbindungstechnologie (Löten) auf der Seite des Gradiometers kombiniert.

Gemäß einer weiteren vorteilhaften Ausgestaltung der Erfindung kann das PbInAu-Bändchen durch jeden anderen Zwischenträger ersetzt werden, solange dieser supraleitend, lötfähig und bondfähig ist, z.B. Niob-Band oder ein mit Niob beschichteter Silizium-Chip, der dann entsprechend auf der Trägerplatte angeordnet ist.

Gemäß einer weiteren Ausgestaltung der Erfindung ist die Trägerplatte mit dem SQUID-Chip in einem supraleitenden Rohr z.B. aus Niob angeordnet, welches aufgrund der vorstehenden erfindungsgemäßen Maßnahmen nur einen Außendurchmesser von ca. 5 mm hat und an seiner Innenseite z.B. durch eine Kapton-Folie elektrisch isoliert ist.

Gemäß einer weiteren Ausgestaltung der Erfindung kann der Boden des Rohres mit einem Deckel z.B. aus Niob verschlossen sein. Überraschenderweise stellte sich jedoch heraus, daß die Abschirmung gegen äußere Magnetfelder auch ohne Deckel ausreichend ist, wenn das SQUID erfindungsgemäß quer zum Rohr angeordnet wird und das Rohr länger als ca. 30 mm ist.

Die Trägerplatte kann gemäß einer weiteren Ausgestaltung der Erfindung durch Federn z.B. aus Federbronze gegen die Innenwand des supraleitenden Rohres gedrückt werden, um mögliche Vibrationen zu verhindern. Unterstützend können hierzu die Zuleitungsdrähte selbst als Federn ausgeführt werden.

Erfindungsgemäß kann gemäß einer weiteren Ausgestaltung der Erfindung der Anschluß an die normalleitenden nach außen führenden Anschlußleitungen, die zur SQUID-Elektronik führen, entweder direkt auf der Trägerplatte erfolgen, oder über einen Zwischenträger, der in einer kleinen normalleitenden Hülse untergebracht sein kann, die mit dem Rohr zusammengesteckt ist.

Überraschenderweise hat sich ferner herausgestellt, daß der üblicherweise im Kryostaten angeordnete Transformator zur Impedanzanpassung immer dann weggelassen, d.h. durch einen einzigen Transformator auf Zimmertemperatur am Eingang der SQUID-Elektronik ersetzt werden kann, wenn die Steilheit der SQUID-Kennlinie den Wert von ca. 30 $\mu V/\Phi_0$ überschreitet. Da das vorliegende SQUID diesen Wert sicher erreicht, kann auch hierdurch vorteilhaft der Aufbau des erfindungsgemäßen SQUID-Moduls wesentlich einfacher und kleiner als der im Stand der Technik bekannte erfolgen.

Ausführungsbeispiele der vorliegenden Erfindung werden nachfolgend unter Bezugnahme auf eine Zeichnung näher erläutert. Darin zeigt:

Fig. 1     ein SQUID-Modul mit einem daran angeschlossenen Gradiometer,

Fig. 2     ein erfindungsgemäßes SQUID-Modul mit verlöteten supraleitenden Verbindungen,

Fig. 3     ein erfindungsgemäßes SQUID-Modul mit teilweise verlöteten supraleitenden Verbindungen, und

Fig. 4     ein erfindungsgemäßes SQUID-Modul entsprechend Fig. 3 unter Verwendung eines beschichteten Verbindungs-Chips.

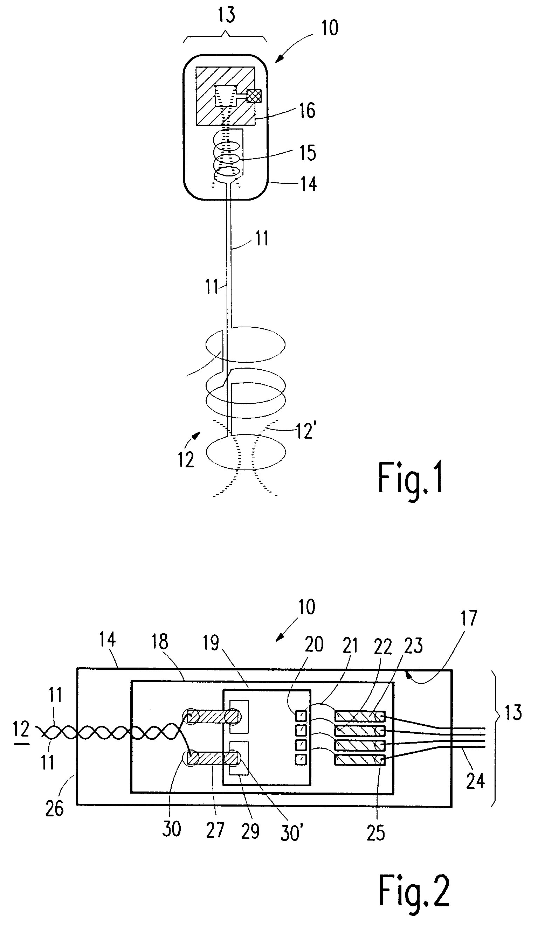

Fig. 1 zeigt schematisch den inneren Aufbau eines SQUID-Moduls 10, das mit nicht dargestellten nach außen führenden Anschlußleitungen einerseits und andererseits über supraleitende Drähte 11 mit einem Gradiometer 12 verbunden ist. Wie eingangs ausgeführt, ist es besonders vorteilhaft, wenn der Abstand zwischen dem SQUID-Modul 10 und dem Gradiometer 12 möglichst gering sein kann und ferner der äußere Durchmesser 13 des SQUID-Moduls 10 möglichst klein ist. Das in dieser Fig. 1 dargestellte SQUID-Modul 10 weist eine supraleitende Abschirmung 14, eine Einkoppelspule 15 und ein SQUID 16 in schematischer Darstellung auf, um das Zusammenspiel der einzelnen Komponenten zu verdeutlichen. Das zu messende Magnetfeld ist mit 12' gekennzeichnet.

Fig. 2 zeigt ein gegenüber Fig. 1 um 90° gedrehtes erfindungsgemäß miniaturisiertes SQUID-Modul 10, dessen supraleitende Abschirmung durch ein Rohr 14 gebildet ist, das vorzugsweise aus Niob besteht. Erfindungsgemäß weist dieses Rohr 14 einen äußeren Durchmesser 13 von nur 5 mm auf. Das Rohr 14 ist auf seiner Innenseite z.B. durch eine nicht näher dargestellte Folie 17 aus Kapton elektrisch isoliert. Im Inneren des Rohres 14 ist eine Trägerplatte 18 angeordnet, die vorzugsweise aus Keramik hergestellt und schmaler als ca. 4 mm ist, so daß sie gut in das Rohr 14 hineingeschoben werden kann und dort mit nicht dargestellter Federn z.B. aus Bronze, die die Trägerplatte 18 an die Innenwand des Rohres 14 drücken, befestigt ist. Diese Befestigung dient gleichzeitig der Vermeidung von möglichen Vibrationen. Zusätzlich können auch noch die Zuleitungsdrähte als Federn, jedenfalls federnd ausgeführt werden.

Auf der keramischen Trägerplatte 18 ist ein SQUID-Chip 19 angeordnet, der den eigentlichen SQUID enthält. Entsprechende Anschlüsse 20 des SQUID-Chips 19 sind über Bonddrähte 21 mit entsprechenden Anschlüssen 22 einer elektronischen Beschaltung 23 ggf. je Kanal aus Leiterbahnen und elektronischen Bauelementen, die in Dickschichttechnik direkt auf der Trägerplatte angeordnet ist, verbunden. Die elektronischen Beschaltungen 23 sind beispielsweise mit nach außen führenden Anschlußdrähten 24 an einer Lötstelle 25 verlötet. Die nach außen führenden Anschlußleitungen 24 können auch über einen nicht dargestellten Zwischenträger, der in einer kleinen normalleitenden Hülse untergebracht sein kann, die mit dem Rohr 14 zusammengesteckt ist, an die elektronische(n) Beschaltung(en) 23 angeschlossen sein. Erfindungsgemäß kann aufgrund der Steilheit der SQUID-Kennlinie auf einen üblicherweise im Kryostaten angeordneten Transformator zur Impedanzanpassung verzichtet und ein einziger nicht dargestellter Zimmertemperatur-Transformator am Eingang der SQUID-Elektronik eingesetzt werden.

Das Rohr 14 kann an seiner zum Gradiometer 12 weisenden (Boden-) Seite mit einem z.B. aus Niob bestehenden Deckel 26 verschlossen sein. Sofern das Rohr 14 jedoch länger als ca. 30 mm ist und das SQUID quer zum Rohr angeordnet ist, kann auf einen Deckel verzichtet werden, da die Abschirmung gegen äußere Magnetfelder dann auch ohne Deckel ausreichend ist.

Der SQUID-Chip 19 ist über einen supraleitenden, lötfähigen als Bändchen ausgebildeten Zwischenträger 27 mit den Drähten 11 des Gradiometers mindestens durch Löten supraleitend verbunden. Die Bändchen 27 sind vorteilhaft aus einer PbInAu-Legierung oder aus Niob. Die Bändchen 27 sind mit den entsprechenden Anschlüssen 29 des SQUID-Chips 19 durch Löten an einer Lötstelle 30' verbunden. Auf ihrer anderen Seite sind die Bändchen 27 mit einer Lötstützstelle 30 auf der Trägerplatte 18 supraleitend verlötet, an die ferner jeweils ein Draht 11 des Gradiometers gelötet ist.

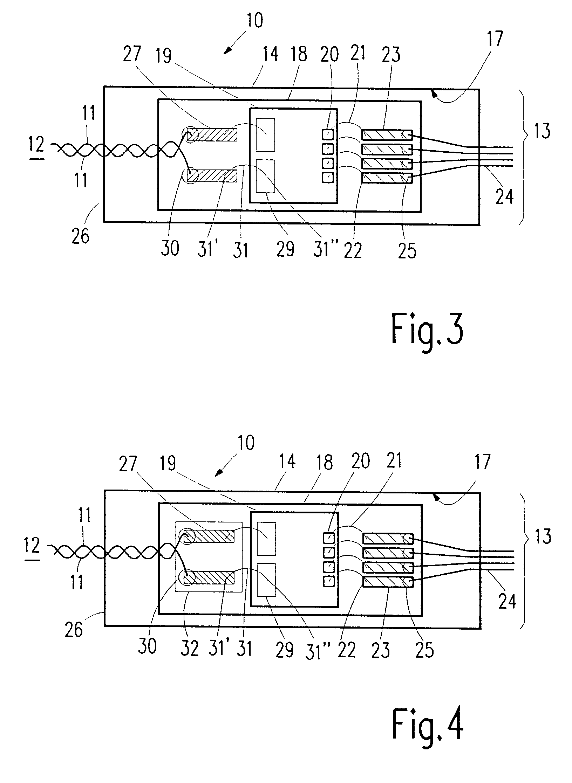

Fig. 3 zeigt eine weitere erfindungsgemäße Ausgestaltung des SQUID-Moduls 10, auf den, mit Ausnahme der supraleitenden Verbindung des SQUID-Chips 19 mit den Drähten 11 die Beschreibung entsprechend Fig. 1 zutrifft. Wie ersichtlich, sind gemäß dieser Ausgestaltung die Bändchen 27 direkt auf der Trägerplatte 18 angeordnet und wie zuvor über Lötstützstellen 30 mit den Drähten 11 verlötet. Die Verbindung zum SQUID-Chip wird jedoch über Bonddrähte 31 hergestellt, die vorzugsweise aus duktilem Niobdraht bestehen. Diese Bonddrähte 31 sind also an den Stellen 31' und 31'' einerseits auf die Bändchen 27 und andererseits auf die entsprechenden Anschlüsse 29 des SQUID-Chips 19 gebondet.

Fig. 4 zeigt eine weitere erfindungsgemäße Alternative der supraleitenden Verbindung zwischen dem SQUID-Chip 19 und den Drähten 11 des Gradiometers 12. Die Beschreibung der übrigen Teile des in Fig. 4 dargestellten SQUID-Moduls 10 entspricht der Beschreibung zu Fig. 1. Wie ersichtlich, ist auch bei dieser weiteren Ausgestaltung der Erfindung ein Zwischenträger quasi als Bändchen 27 vorgesehen, der einerseits über eine Lötstützstelle 30 mit einem Draht 11 verlötet ist und andererseits über einen Bonddraht 31 an der Stelle 31' mit den entsprechenden Anschlüssen 29 an der Stelle 31'' des SQUID-Chips 19 verbunden ist. Die Bändchen 27 sind bei dieser Ausgestaltung jedoch als Niobbeschichtung auf einem Siliziumchip 32 ausgeführt, der seinerseits auf der Trägerplatte 18 fest angeordnet, beispielsweise aufgeklebt ist.

Die in den Fig. 3 und 4 genannten Verbindungsmöglichkeiten kombinieren in vorteilhafter Weise die mikroskopische Verbindungstechnologie des Bondens auf der Seite des SQUID-Chips 19 mit der makroskopischen Verbindungstechnologie des Lötens auf der Seite des Gradiometers. Durch die erfindungsgemäßen vorstehenden Maßnahmen kann der Aufbau des SQUID-Moduls 10 wesentlich einfacher und kleiner als im Stand der Technik mit den genannten Vorteilen erfolgen.

Die in der vorstehenden Beschreibung, in den Fig. 1, 2, 3 und 4 sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Miniaturisiertes SQUID-Modul insbesondere für Vielkanal-Magnetometer zur Messung sich ändernder Magnetfelder in einem Feldstärkebereich unter $10^{-10}$ T, insbesondere unter $10^{-12}$ T, mit supraleitenden und geschirmten Verbindungen zwischen einem SQUID-Chip und einem Gradiometer,
dadurch gekennzeichnet, daß der SQUID-Chip (19) auf einer nur einige Millimeter breiten vollständig geschirmten Trägerplatte (18) mit elektronischer Beschaltung (23) angeordnet ist und daß der SQUID-Chip (19) über einen supraleitenden, lötfähigen und bondfähigen Zwischenträger (27) mindestens durch Löten mit den Drähten (11) des Gradiometers (12) supraleitend verbunden ist.

2. SQUID-Modul nach Anspruch 1,
dadurch gekennzeichnet, daß als Zwischenträger schmale Bändchen (27) aus einer PbInAu-Legierung oder aus Niob vorgesehen sind, die einerseits mit Anschlüssen (29) des SQUID-Chips (19) supraleitend verbunden und andererseits supraleitend mit je einer Lötstützstelle (30) der Trägerplatte (18) verlötet sind, an die ferner je ein Draht (11) des Gradiometers (12) gelötet ist.

3. SQUID-Modul nach Anspruch 2,
dadurch gekennzeichnet, daß die Verbindungen der schmalen Bändchen (17) mit den Anschlüssen (29) des SQUID-Chips (19) durch Löten an Lötstellen (31') hergestellt sind.

4. SQUID-Modul nach Anspruch 2,
dadurch gekennzeichnet, daß die Verbindung der schmalen Bändchen (27) mit den Anschlüssen (29) des SQUID-Chips (19) über einen supraleitenden Bonddraht (31) aus duktilem Niob hergestellt ist, wobei die Bändchen (27) auf der Trägerplatte (18) fest angeordnet, z.B. verklebt sind.

5. SQUID-Modul Anspruch 4,
dadurch gekennzeichnet, daß die schmalen Bändchen (27) durch niobbeschichtete Streifen auf einem auf der Trägerplatte (18) angeordneten Silizium-Chip (32) gebildet sind.

6. SQUID-Modul nach einem oder mehreren der vorhergehenden Ansprüche,
dadurch gekennzeichnet, daß die elektronische Beschaltung (23) aus Leiterbahnen und elektronischen Bauelementen in Dickschichttechnik direkt auf der Trägerplatte (18) angeordnet ist und über Bonddrähte (21) einerseits mit den entsprechenden Anschlüssen (20) des SQUID-Chips (19) und andererseits über Lötstellen (25) mit den nach außen führenden Anschlußdrähten (24) verbunden ist.

7. SQUID-Modul nach Anspruch 6,
dadurch gekennzeichnet, daß die Trägerplatte (18) aus Keramik und schmaler als ca. 4 mm ist, und daß der SQUID-Chip (19) auf die Trägerplatte (18) geklebt und gebondet ist.

8. SQUID-Modul nach Anspruch 7,
dadurch gekennzeichnet, daß die Trägerplatte (18) mit dem SQUID-Chip (19) zur Abschirmung in einem supraleitenden Rohr (14) angeordnet ist, welches an seiner Innenseite durch eine Folie (17) elektrisch isoliert ist.

9. SQUID-Modul nach Anspruch 8,
dadurch gekennzeichnet, daß das Rohr (14) einen Außendurchmesser (13) von ca. 5 mm nicht überschreitet und aus Niob und die Folie (17) aus Kapton hergestellt ist.

10. SQUID-Modul nach Anspruch 9,
dadurch gekennzeichnet, daß der Boden des Rohres (14) mit einem Deckel (26) aus Niob verschlossen ist.

11. SQUID-Modul nach Anspruch 9,
dadurch gekennzeichnet, daß der SQUID-Chip (19) quer zum Rohr (14) angeordnet und das Rohr (14) länger als ca. 30 mm ist.

12. SQUID-Modul nach Anspruch 10 oder 11,
dadurch gekennzeichnet, daß die Trägerplatte (18) durch Federn gegen die Wand des Rohres (14) gedrückt wird, und daß die Drähte federnd ausgebildet sind, um Vibrationen zu verhindern, wobei die Federn aus Bronze sind.

13. SQUID-Modul nach einem oder mehreren der vorhergehenden Ansprüche, dadurch gekennzeichnet, daß die nach außen führenden Anschlußleitungen (24) über einen Zwischenträger mit der elektronischen Beschaltung (23) verbunden sind, und der Zwischenträger in einer kleinen normalleitenden Hülse untergebracht ist, die mit dem Rohr (14) zusammengesteckt ist.

14. SQUID-Modul nach einem oder mehreren der vorhergehenden Ansprüche, dadurch gekennzeichnet, daß erforderliche Transformatoren zur Impedanzmessung durch einen einzigen Zimmertemperatur-Transformator am Eingang der erforderlichen Elektronik ersetzt ist, da die Steilheit der SQUID-Kennlinie einen Wert von ca. 30 $\mu$V/$\Phi_0$ überschreitet.

Fig.1

Fig.2

Fig.3

Fig.4